# EUROPÄISCHE PATENTSCHRIFT

(11) **EP 3 680 678 B1**
(45) Veröffentlichungstag und Bekanntmachung des Hinweises auf die Patenterteilung: **28.08.2024**
(21) Anmeldenummer: 20151706.7
(22) Anmeldetag: 14.01.2020
(51) Int. Cl.: G01R 31/58, G01R 19/00

(54) **MESS-SYSTEM ZUR ERFASSUNG VON STÖRUNGEN AUF LEITUNGEN EINES GERÄTES ODER EINER ANLAGE**
MEASURING SYSTEM FOR DETECTING INTERFERENCE ON LINES OF AN DEVICE OR A SYSTEM
SYSTÈME DE MESURE PERMETTANT DE DÉTECTER DES PERTURBATIONS SUR LES LIGNES D'UN APPAREIL OU D'UNE INSTALLATION

(30) Priorität: 14.01.2019 DE 102019200333
(43) Veröffentlichungstag der Anmeldung: 15.07.2020
(73) Patentinhaber: PHOENIX CONTACT GmbH & Co. KG, 32825 Blomberg (DE)
(72) Erfinder: Derksen, Johann, 33034 Brakel (DE); Meyer zu Heiligen, Daniel, 32107 Bad Salzuflen (DE)
(74) Vertreter: RCD-Patent Giesen, Schmelcher & Griebel Patentwanwälte PartG mbB

(56) Entgegenhaltungen:
- WO-A1-2010/096852
- DE-U1- 202011 110 723
- US-A1- 2004 201 373
- US-A1- 2014 253 109

## Beschreibung

Die Erfindung betrifft ein Mess-System zur Erfassung von Störungen auf Leitungen eines Gerätes oder einer Anlage.

### Hintergrund der Erfindung

Elektrische Geräte und Anlagen werden zunehmend empfindlicher gegen Überspannungen.

Im Niederspannungsnetz treten sowohl energiearme als auch energiereiche Störungen auf.

Durch äußere Einflüsse wie z.B. Blitzereignisse koppeln energiereiche Störungen in das Niederspannungsnetz ein.

Durch den zunehmenden Einsatz von Halbleitertechnologien und/oder Schalthandlungen (z.B. durch Motoren, Schütze), treten auch vermehrt energiearme Störungen im Niederspannungsnetz auf.

Durch die zusätzliche, zunehmende Miniaturisierung elektrischer Bauteile nimmt die Empfindlichkeit gegenüber Störungen jeglicher Art zu.

Energiereiche Impulse treten dabei seltener auf als energiearme Impulse.

Um die empfindlichen Baugruppen vor diesen Störungen zu schützen werden Überspannungsschutzeinrichtungen eingesetzt. Diese leiten den mit einer Überspannung einhergehenden Impulsstrom ab.

Die energiearmen Störungen (Impulse) lösen eine Überspannungsschutzeinrichtung in der Regel nicht aus, können aber bei einer hohen Repititionsrate zu dauerhaften Schäden in der Anlage führen.

Um Störungen und ihren Einfluss auf Netze und Überspannungsableiter erfassbar zu machen wurden in der Vergangenheit unterschiedlichste Geräte entwickelt.

Beispielsweise ist es bekannt energiereiche Überspanungsereignisse mit einem Impulszähler zu zählen.

Andererseits können Blitzströme auch gemessen werden. Hierzu bietet z.B. die Anmelderin Geräte an.

Aber auch für den Laborgebrauch finden sich unterschiedliche Mess-Sonden.

Allerdings sind die vorbezeichneten Geräte nicht in der Lage energiearme Störungen sicher zu detektieren.

Zur Erfassung energiearmer Störungen wurden in der Vergangenheit bei der Bemusterung von Geräten Tests zur sogenannten elektromagnetischen Verträglichkeit vorgeschlagen.

Zur Auswertung ist beispielsweise aus der DE 42 12 751 C2 eine digitale Schaltung bekannt, die elektromagnetische Verträglichkeit digitaler Baugruppen messen kann.

Aus der DE 295 14 423 U1 ist ein EMV-Kompaktsensor bekannt.

Aus der DE 37 42 397 C1 ist ein Netzanalysegerät zur Identifikation, Analyse, Registrierung, Speicherung und Meldung von elektromagnetischen Störfällen bekannt.

Aus der DE 195 07 809 C2 ist ein Messverfahren zur Erfassung pulsförmiger Störgrößen bekannt.

Jedoch sind diese Geräte nicht für die Überwachung des laufenden Betriebes geeignet und in der Regel nicht zur Erfassung von energiereichen Störungen geeignet.

Zudem ist bei den vorgenannten Geräten entweder ein Eingriff in das Gerät notwendig und/oder durch das Messgerät werden Signale auf den Leitungen zum Gerät durch die Messung verändert. Dabei kann ein Verlust an Information auftreten.

Weiterhin ist aus dem Stand der Technik die internationale Patentanmeldung WO 2010 / 096 852 A1 bekannt, in der eine Detektoreinheit zur Detektion hochfrequenter elektrischer Störungen in elektrischen Netzen bekannt, die es erlaubt das Vorhandensein einer Störung zu erkennen, jedoch nicht zu unterscheiden.

Darüber hinaus ist aus dem Dokument DE 20 2011 110 723 U1 ein Schutzschalter und ein Verfahren zur Erkennung von Störlichbögen bekannt.

### Aufgabe

Es ist daher eine Aufgabe der Erfindung ein Mess-System zur Verfügung zu stellen, das sowohl energiereiche als auch energiearme Störungen erfassen kann, ohne dass ein mögliches Nutzsignal nennenswert verändert wird.

Die Lösung der Aufgabe erfolgt erfindungsgemäß durch die Merkmale des unabhängigen Anspruchs. Vorteilhafte Ausgestaltungen der Erfindung sind in den Unteransprüchen, der Beschreibung und den Figuren angegeben.

Nachfolgend wird die Erfindung unter Bezugnahme auf die anliegenden Zeichnungen anhand bevorzugter Ausführungsformen näher erläutert.

Es zeigen
- Fig. 1: eine schematische Anordnung einer Sensoreinheit gemäß Ausführungsformen der Erfindung,
- Fig. 2: eine schematische Anordnung einer Sensoreinheit und Auswerteeinrichtung gemäß Ausführungsformen der Erfindung,
- Fig. 3: eine schematische Anordnung von Leitungswegen von Gegentaktsignalen gemäß Ausführungsformen der Erfindung,
- Fig. 4: eine schematische Anordnung von Leitungswegen von Gegentaktsignalen bei Verwendung eines gemeinsamen Bezugspunktes gemäß Ausführungsformen der Erfindung,
- Fig. 5: eine schematische Anordnung von Leitungswegen von Gleichtaktsignalen,
- Fig. 6: eine schematische Anordnung von Leiterbahnen zur Bereitstellung von Gegentaktsignalen und Gleichtaktsignalen gemäß Ausführungsformen der Erfindung,
- Fig. 7: eine beispielhafte Auswertelogik gemäß Ausführungsformen der Erfindung
- Fig. 8: Leiterbahnen in Bezug auf eine erste Leiterbahnebene in Bezug auf Gegentaktsignal gemäß Ausführungsformen der Erfindung,
- Fig. 9: Leiterbahnen in Bezug auf eine zweite Leiterbahnebene in Bezug auf Gegentaktsignal gemäß Ausführungsformen der Erfindung,
- Fig. 10: Leiterbahnen in Bezug auf eine Leiterbahnebene in Bezug auf ein Gleichtaktsignal gemäß Ausführungsformen der Erfindung, und
- Fig. 11: eine schematische Anordnung von Elementen gemäß Ausführungsformen der Erfindung.

Nachfolgend wird die Erfindung eingehender unter Bezugnahme auf die Figuren dargestellt werden. Dabei ist anzumerken, dass unterschiedliche Aspekte beschrieben werden, die jeweils einzeln oder in Kombination zum Einsatz kommen können. D.h. jeglicher Aspekt kann mit unterschiedlichen Ausführungsformen der Erfindung verwendet werden soweit nicht explizit als reine Alternative dargestellt.

Weiterhin wird nachfolgend der Einfachheit halber in aller Regel immer nur auf eine Entität Bezug genommen. Soweit nicht explizit vermerkt, kann die Erfindung aber auch jeweils mehrere der betroffenen Entitäten aufweisen. Insofern ist die Verwendung der Wörter "ein", "eine" und "eines" nur als Hinweis darauf zu verstehen, dass in einer einfachen Ausführungsform zumindest eine Entität verwendet wird.

Soweit nachfolgend Verfahren beschrieben werden, sind die einzelnen Schritte eines Verfahrens in beliebiger Reihenfolge anordbar und/oder kombinierbar, soweit sich durch den Zusammenhang nicht explizit etwas Abweichendes ergibt. Weiterhin sind die Verfahren - soweit nicht ausdrücklich anderweitig gekennzeichnet - untereinander kombinierbar.

Angaben mit Zahlenwerten sind in aller Regel nicht als exakte Werte zu verstehen, sondern beinhalten auch eine Toleranz von +/- 1 % bis zu +/- 10 %.

Soweit in dieser Anmeldung Normen, Spezifikationen oder dergleichen benannt werden, werden zumindest immer die am Anmeldetag anwendbaren Normen, Spezifikationen oder dergleichen in Bezug genommen. D.h. wird eine Norm / Spezifikation etc. aktualisiert oder durch einen Nachfolger ersetzt, so ist die Erfindung auch hierauf anwendbar.

Soweit nachfolgend der Begriff Wicklung verwendet wird, ist dabei insbesondere ein Leiterschleife oder eine Vielzahl von Leiterschleifen mitbezeichnet.

Soweit nachfolgend Bezug auf eine Leitung genommen wird, ist damit sowohl eine Zu- / Ableitung als auch eine interne elektrische Verbindung innerhalb eines Gerätes oder einer Anlage bezeichnet.

In den Figuren sind verschiedene Ausführungsformen dargestellt.

Die Erfindung ermöglicht die Erfassung von energiereichen und energiearmen Impulsen ohne gegenseitige Beeinflussung. Insbesondere kann durch die Erfindung eine gleichzeitige Erfassung von energiereichen und energiearmen Impulsen ohne gegenseitige Beeinflussung bereitgestellt werden.

Dazu macht sich die Erfindung zu Nutze, dass energiereiche Störungen (z.B. Impulse) im Frequenzbereich bis zu einigen hundert kHz auftreten, energiearme Störungen jedoch Frequenzen bis zu mehreren hundert MHz aufweisen.

Durch die Erfindung ist es möglich (impulsartige) Störungen zu erfassen, die Frequenzen von 1 Hz bis hin zu mehreren hundert MHz oder in den GHz-Bereich aufweisen.

Insbesondere erlaubt die Erfindung einen Frequenzbereich, der sowohl typische energiearme als auch typische energiereiche Störungen umfasst, in Bezug auf die Frequenz lückenlos zu erfassen.

Die Erfindung ermöglicht dabei eine kontinuierliche Überwachung.

Eine solche kontinuierliche Überwachung erlaubt z.B. rückwirkend Schlüsse durch die aufgezeichnete Historie. Bei Ausfällen von Geräten können die Daten helfen die Ausfallursache zu finden.

Beispielsweise können Ereignisdaten der Auswerteeinheit AE mit anderen Ereignissen verknüpft werden.

Wenn beispielsweise eine Lüfter-Steuerung in einem Gehäuseabschnitt häufiger ausfällt, kann aufgrund der Vergleichsdaten geschlussfolgert werden, inwieweit Netzstörungen (z.B. Überspannungen) die Ursache sind. Ist eine Störungsquelle lokalisiert kann eine entsprechende Abhilfe gesucht werden.

Außerdem können bei Veränderungen in einer Anlage vermehrt Störungen auftreten, die mit Hilfe der Daten diagnostiziert werden können.

Wenn beispielsweise ein neuer Motor eingebaut wird und dadurch vermehrt Störungen auftreten, kann anhand eines Zeitstempels der Ereignisdaten der Auswerteeinheit AE auf die Inbetriebnahme des Motors geschlossen werden.

Das Mess-System 1 zur Erfassung von Störungen auf Leitungen zu einem Gerät oder einer Anlage weist zumindest eine Auswerteeinheit AE und zumindest eine Sensoreinheit S1 auf.

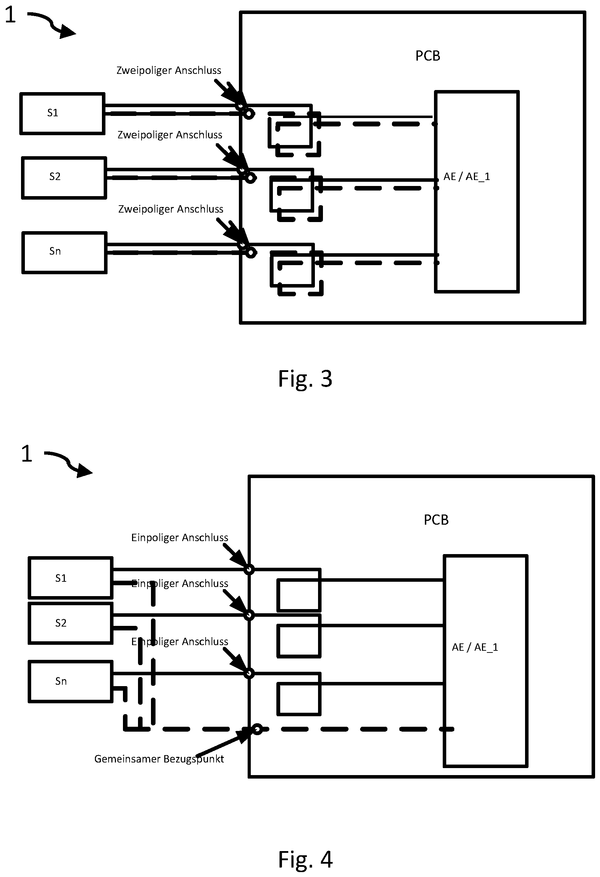

Ohne Beschränkung der Allgemeinheit kann das Mess-System auch mehr als eine Sensoreinheit S1 aufweisen. Beispielsweise sind in den Figuren 3 - 5 drei Sensoreinheiten S1, S2, ... Sn aufgezeigt. Die Anzahl kann z.B. durch die Anzahl der Anschlussmöglichkeiten solcher Sensoreinheiten an die Auswerteeinheit AE beschränkt sein.

Die Sensoreinheiten S1, S2, Sn sind dabei insbesondere induktive Sensoren, in denen ein Nutzsignal induziert wird.

Induktive Sensoren haben den Vorteil, dass kein Eingriff in eine Schaltung notwendig ist. Vielmehr kann ein Streufeld, welches um eine Daten- und/oder Versorgungsleitung vorhanden ist genutzt werden, um induktiv das Streufeld als Informationsquelle zu nutzen, ohne das Nutzsignal auf der Daten- / und/oder Versorgungsleitung zu verändern. Weiterhin stellen induktive Sensoren S1, S2, Sn eine erste Isolation des Mess-Systems 1 gegenüber der zu überwachenden Leitung zur Verfügung.

Solche Sensoren stellen der Auswerteeinheit AE ein differentielles Signal insbesondere für energiereiche Impulse zur Verfügung. Das differentielle Signal (Gegentaktsignal) wird auf zwei Leitern transportiert. Durch eine hohe Isolation der Sensoreinheit S1 gegenüber der Anlage / dem Gerät wird eine (ausreichend hohe) Kapazität in Bezug hierauf bereitgestellt, sodass die Sensoreinheit S1 der Auswerteeinheit AE zugleich auch ein Gleichtaktsignal bereitstellen kann.

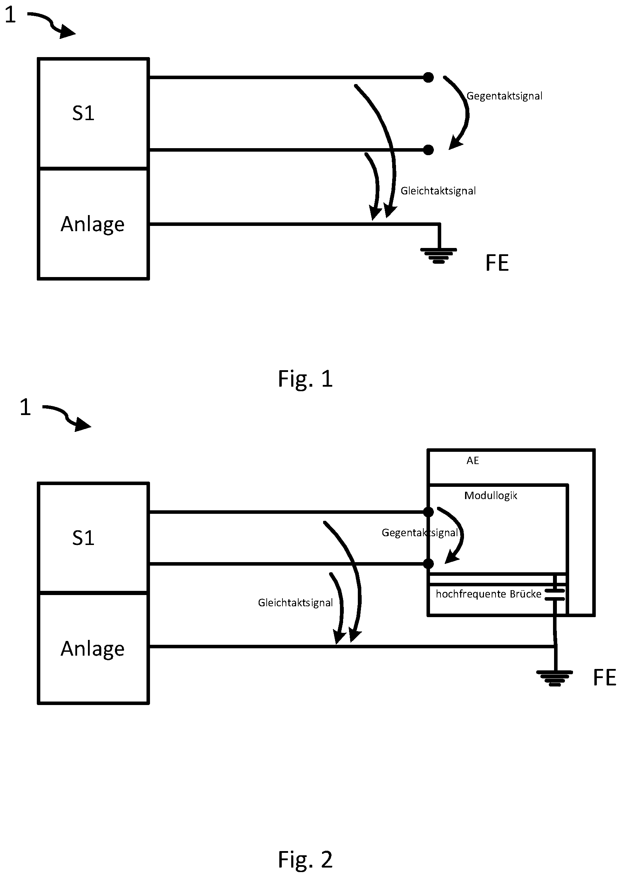

Weiterhin kann durch Bereitstellung einer im hochfrequenten Frequenzbereich niederohmigen Verbindung eines der beiden Leiter der Sensoreinheit S1, S2, Sn zu einem Erdleiter der Anlage dazu verwendet werden, das Gleichtaktsignal der Auswerteinheit AE zur Verfügung zu stellen. Eine solche im hochfrequenten Frequenzbereich niederohmigen Verbindung kann durch einen geeignet dimensionierten Kondensator zur Verfügung gestellt werden, sodass nunmehr das auf beiden Leitern gleichgetaktete Hochfrequenzsignal erfassbar wird. Die im hochfrequenten Frequenzbereich niederohmige Verbindung ist in Figur 2 als hochfrequente Brücke bezeichnet. Je nach Dimensionierung stellt der Kondensator für bestimmte Frequenzen sogar einen Kurzschluss dar.

Das Mess-System 1 ist weiterhin eingerichtet in Bezug auf eine Störung festzustellen, ob die Störung in Bezug auf eine vorbestimmte Grenzfrequenz hochfrequent oder niederfrequent ist, wobei das Mess-System 1 weiterhin eingerichtet ist Daten in Bezug auf eine Störung oder mehrere Störungen bereitzustellen.

Die Bereitstellung von Daten kann an der Auswerteeinheit AE mittels eines lokalen Displays DIS zur Verfügung gestellt werden. Gleichfalls kann z.B. auch vorgesehen sein, dass an der Auswerteeinheit AE Schaltelemente vorgesehen sind, um eine Historie vergangener (gespeicherter) Störungen und zughörige Ereignisdaten auswerten zu können.

Ohne Beschränkung der Allgemeinheit kann alternativ oder zusätzlich vorgesehen sein, dass das Mess-System 1 weiterhin eine Kommunikationsschnittstelle I/O aufweist.

Über die Kommunikationsschnittstelle können einzelne und/oder mehrere (gespeicherte) Störungen bzw. ihre Ereignisdaten (Energie, Spannung, Strom, Dauer, Frequenz, Zeit, etc.) zur weiteren Bewertung bereitgestellt werden. Insbesondere kann die Kommunikationsschnittstelle I/O eine standardisierte drahtlose oder drahtgebundene Schnittstelle aufweisen. Bereitstellung im Sinne der Anmeldung meint dabei sowohl eine aktive Bereitstellung, sodass Ereignisdaten unmittelbar / zeitversetzt / periodisch an ein anderes Gerät übermittelt werden als auch eine Bereitstellung zur Abholung / Abruf durch ein anderes Gerät.

Erfindungsgemäß ist zwischen der Sensoreinheit S1 und der Auswerteeinheit AE ein Übertrager Ü mit einer Primärseite und einer Sekundärseite angeordnet, wobei die Sensoreinheit S1 an der Primärseite anschließbar ist. Eine Untereinheit der Auswerteeinheit AE kann an die Sekundärseite angeschlossen sein.

Der Übertrager Ü stellt dabei eine galvanische Trennung zur Verfügung. Zudem kann durch geeignete Wahl des Übertragungsverhältnisses der Spannungspegel für die Auswerteeinheit AE geeignet angepasst sein. Zudem wird eine weitere Entkoppelung vom Nutzsignal bereitgestellt.

Besonders kostengünstig kann ein solcher Übertrager Ü auf einer Platine PCB ausgeführt sein. Beispielsweise kann ein erster angeschlossener Leiter der Sensoreinheit auf der Leiterplatte des Gerätes in einer Leiterschleife auf einer Platine verlegt sein. Diese Leiterschleife stellt die Primärwicklung eines in der Platine realisierten Übertragers Ü dar.

Bei einem mehrpolig ausgeführten Anschluss, können alle Leiter, die zu einem Anschluss (einer Anlage/eines Gerätes) gehören auf gleiche Weise (gleicher Wicklungssinn) parallel verlegt sein. Sie bilden dann gemeinsam die Primärwicklung des Übertragers Ü.

In Figur 3 ist zudem eine Ausführungsform gezeigt, bei der mehrere Sensoreinheiten mit jeweils einem zweipoligen Anschluss zu einer Platine PCB geführt sind. In diesem Fall hat jede Sensoreinheit einen eigenen Bezugspunkt. Die Leiterschleifen eines jeden zweipoligen Anschlusses sind - wie weiter unten dargestellt wird - z.B. gleichsinnig übereinander angeordnet. In Figur 4 hingegen ist eine Ausführungsform gezeigt, bei der mehrere Sensoreinheiten mit jeweils einem einpoligen Anschluss zu einer Platine geführt sind. In diesem Fall haben mehrere Sensoreinheiten einen gemeinsamen Bezugspunkt.

Die Sekundärwicklung des Übertragers Ü kann auf der gleichen oder mindestens einer weiteren Lage innerhalb der Platine PCB liegen. Die Anzahl der Windungen der Sekundärwicklung ist dabei abhängig von der gewünschten Induktionsspannung auf der Sekundärseite für die weitere Ausweitung.

Die Sekundärwicklung des Übertragers Ü kann dabei mit einem Leiterbahnende mit einem Referenzpotential (z.B. Ground / GND) verbunden sein. Das andere Leiterbahnende der Wicklung kann auf der anderen Seite mit einer Auswertelogik der Auswerteeinheit AE / AE_2 verbunden sein. Die Auswerteeinheit AE / AE_2 ist in der Lage die hochfrequenten Störimpulse zu erfassen und auszuwerten. Die Auswertung kann z.B. mit einem speichernden CMOS-Flip-Flop erfolgen.

In einer Ausführungsform der Erfindung weist die Auswerteeinheit AE einen Analog/DigitalWandler auf. Dabei ist es nicht notwendig einen mehrstufigen A/D-Wandler bereitzustellen. Vielmehr kann es ausreichend sein lediglich einen Binärwandler bereitzustellen.

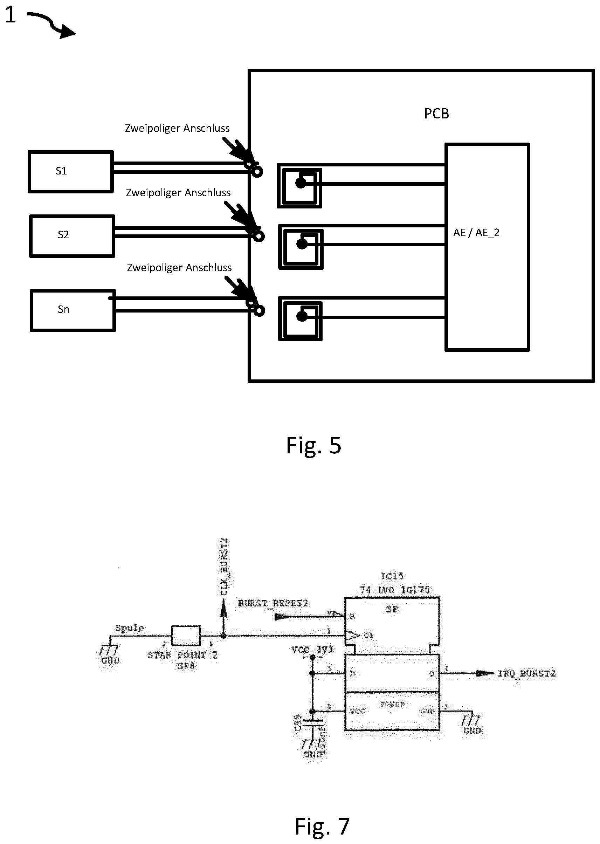

Eine beispielhafte Auswertung kann z.B. mit einer Kippstufe erfolgen, wie sie in Figur 7 dargestellt ist. Diese führt eine 1-bittige A/D-Wandlung durch.

In einer Ausführungsform der Erfindung ist die Grenzfrequenz zur Unterscheidung hochfrequent / niederfrequent ausgewählt aus einem Bereich von 250 kHz bis 1 MHz.

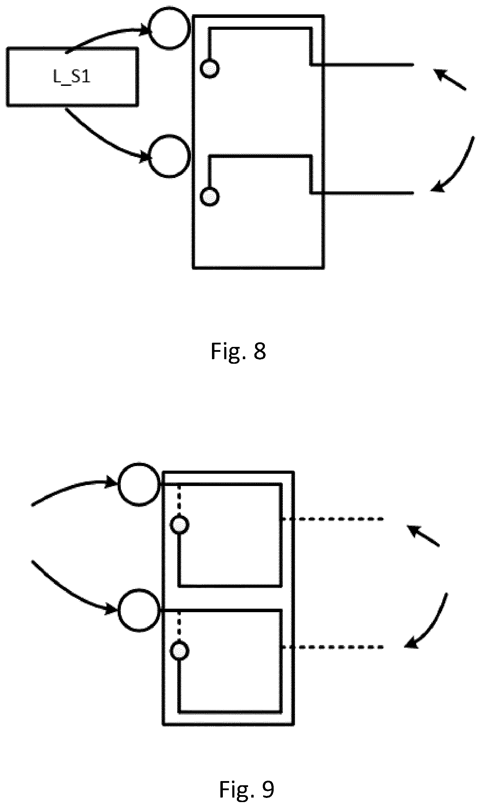

Beispielsweise ist in Figur 8 der Verlauf von Leiterbahnen einer ersten Leiterebene dargestellt. In Figur 9 ist ebenfalls der Verlauf von Leiterbahnen einer zweiten Leiterebene dargestellt. Beide Ebenen zusammen stellen den Leitungsweg des Gegentaktsignales dar. Das Gegentaktsignal wird über Leitungen L_S1 der Sensoreinheit S1 zugeführt. Das durchlaufende Gegentaktsignal wird dann über Leiterbahnen L_AE der Auswerteelektronik AE/AE_1 für energiereiche Störungen zugeführt.

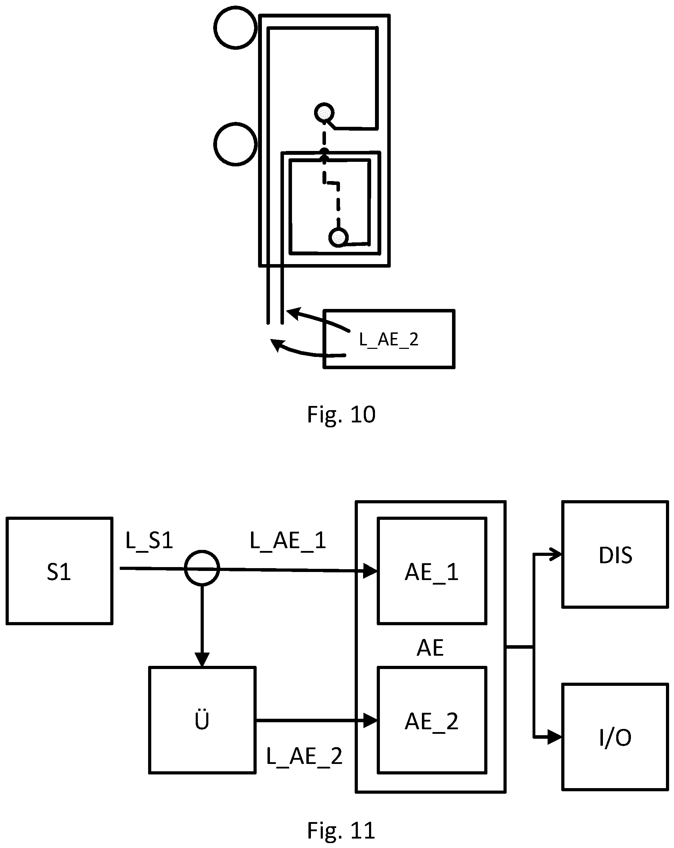

Das Gleichtaktsignal zur Detektion der energiearmen Störungen kann wie in Figur 8 und 9 dargestellt mittels einer Leitung des Sensorelements L_AE_1 abgeführt werden. An diese Leitung induktiv angekoppelt ist wie in Figur 10 dargestellt eine Leiterschleife L_AE_2, welche dargestellt zwei Leiterschleifen aufweist. Dabei ist zu beachten, dass in Figur 10 nur die Sekundärseite des Übertragers Ü dargestellt ist, während sich eine Primärseite z.B. aus einer Darstellung der Figuren 8 oder 9 ergibt. Offensichtlich kann die Zahl der Leiterschleifen entsprechend angepasst werden.

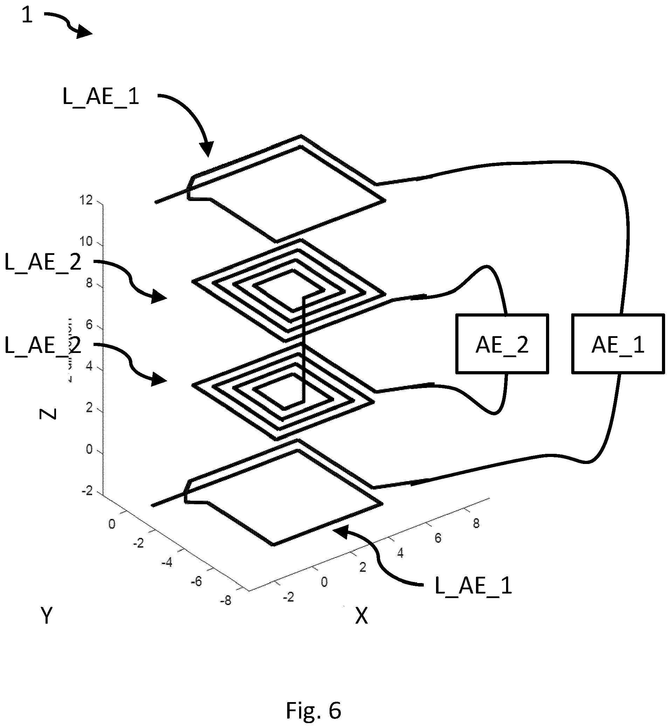

Obwohl in der Figur 10 die Anordnung nebeneinander in Bezug auf den gebildeten Übertrager Ü dargestellt ist, ist die Erfindung nicht hierauf beschränkt. Vielmehr können die Leiterstrukturen wie in Figur 6 dargestellt auch in verschiedenen Leiterschichten, z.B. einer Platine, angeordnet sein. Dann bilden die Leiterbahnen L_AE_1 und L_AE_2 die entsprechenden Weiterleitungen / Übertrager Ü aus.

Durch diese Anordnung wird wie in den Figuren 1 und 2 gegenüber Figur 3 eine Trennung des energiearmen Gleichtakt- von dem energiereichen Gegentaktsignal bereitgestellt. Dies ermöglicht es, dass die jeweiligen Signale voneinander unbeeinflusst in unterschiedlichen Unterauswerteeinheiten AE_1 bzw. AE_2 erfasst und verarbeitet werden können.

Dabei stellt der so gebildete Übertrager Ü eine galvanische Trennung des Gleichtaktsignals zur Verfügung.

Die Eingangsleitungen L_S1, die an der Sensoreinheit S1 angeschlossen sind, können gleichsinnig in je einer (oder mehreren) Leiterschleife(n) verlegt sein.

Dadurch wird das Gegentaktsignal praktisch nicht beeinflusst.

Der Übertrager Ü kann benachbart oder bevorzugt auf mindestens einer anderen Lage der Leiterplatte wiederum als eine oder mehrere Leiterschleife(n) ausgeführt sein.

Dadurch ergibt sich eine hochfrequente (elektromagnetische) Kopplung.

Die Kopplung kann bevorzugt ohne ferromagnetische Materialien ausgeführt sein, da solche Materialien die Linearität beeinflussen und/oder zu einer (Teil-)Auslöschung eigentlich gewünschter Signale führen können.

D.h. in Ausführungsformen können die Störungen getrennt erfasst werden. Beispielsweise können niederfrequente Störungen in einer ersten Unterauswerteeinheit AE_1 und hochfrequente Störungen in einer zweiten Unterauswerteeinheit AE_2 erfasst werden. Weiterhin erlaubt eine solche Anordnung nicht nur die bauliche Trennung sondern auch eine gleichzeitige Erfassung niederfrequenter und hochfrequenter Störungen.

In einer weiteren Ausführungsform wird wie in Figur 2 gezeigt eine Verbindung zu einem gemeinsamen Erdpotential mit der Anlage / dem Gerät, z.B. zu einer Funktionserdung, bereitgestellt.

Insbesondere ist das Mess-System 1 für Leitungen geeignet, die zumindest zeitweise eine niederfrequente Spannung aufweisen.

### Bezeichnungsliste

- 1: Mess-System
- AE: Auswerteeinheit
- S1, S2, ... Sn: Sensoreinheit
- I/O: Kommunikationsschnittstelle
- Ü: Übertrager
- PCB: Platine
- FE: Funktionserdung
- AE_1, AE_2: Unterauswerteeinheit
- L_AE: Leitung zur Auswerteeinheit
- L_S1: Leitung zur Sensoreinheit
- L_AE_1: Leitung zur Unterauswerteeinheit
- L_AE_2: Leitung zur Unterauswerteeinheit
- DIS: Display

## Patentansprüche

1. Mess-System (1) zur Erfassung von Störungen auf einer Leitung eines Gerätes oder einer Anlage, aufweisend eine Auswerteeinheit (AE) und zumindest eine Sensoreinheit (S1), wobei das Mess-System (1) weiterhin eingerichtet ist in Bezug auf eine Störung festzustellen, ob die Störung in Bezug auf eine vorbestimmte Grenzfrequenz höherfrequent oder niederfrequent ist, wobei das Mess-System (1) weiterhin eingerichtet ist Daten in Bezug auf ein oder mehrere Störung(en) bereitzustellen **dadurch gekennzeichnet, dass** zwischen der Sensoreinheit (S1) und der Auswerteeinheit (AE) ein Übertrager (Ü) mit einer Primärseite und einer Sekundärseite angeordnet ist, wobei die Sensoreinheit (S1) an der Primärseite anschließbar ist.

2. Mess-System nach Anspruch 1, **dadurch gekennzeichnet, dass** das Mess-System (1) weiterhin eine Kommunikationsschnittstelle (I/O) aufweist.

3. Mess-System nach Anspruch 1 oder 2, **dadurch gekennzeichnet, dass** die Sensoreinheit (S1) ein differentielles Signal zur Verfügung stellt.

4. Mess-System nach einem der vorhergehenden Ansprüche, **dadurch gekennzeichnet, dass** die Auswerteeinheit (AE) einen Analog/Digital-Wandler aufweist.

5. Mess-System nach einem der vorhergehenden Ansprüche, **dadurch gekennzeichnet, dass** die Sensoreinheit (S1) ein induktiver Sensor ist.

6. Mess-System nach einem der vorhergehenden Ansprüche, **dadurch gekennzeichnet, dass** zwischen der Sensoreinheit (S1) und der Auswerteeinheit (AE) ein Übertrager (Ü) mit einer Primärseite und einer Sekundärseite angeordnet ist, wobei der Übertrager (Ü) mittels Leiterbahnen einer Platine (PCB) ausgeführt ist.

7. Mess-System nach einem der vorhergehenden Ansprüche, **dadurch gekennzeichnet, dass** die Auswerteeinheit (A) eingerichtet ist um eine Vielzahl von Sensoreinheiten (S1, ... S4) zu überwachen.

8. Mess-System nach einem der vorhergehenden Ansprüche, **dadurch gekennzeichnet, dass** die Grenzfrequenz zur Unterscheidung hochfrequent / niederfrequent ausgewählt ist aus einem Bereich von 250 kHz bis 1 MHz.

9. Mess-System nach einem der vorhergehenden Ansprüche, **dadurch gekennzeichnet, dass** weiterhin eine Verbindung zu einer Funktionserdung (FE) bereitstellt.

10. Mess-System nach einem der vorhergehenden Ansprüche, **dadurch gekennzeichnet, dass** niederfrequente Störungen in einer ersten Unterauswerteeinheit (AE_1) und die hochfrequente Störungen in einer zweiten Unterauswerteeinheit (AE_2) erfasst werden.

11. Mess-System nach einem der vorhergehenden Ansprüche, **dadurch gekennzeichnet, dass** niederfrequente Störungen in einer ersten Unterauswerteeinheit (AE_1) und die hochfrequente Störungen in einer zweiten elektrisch von der ersten Unterauswerteeinheit (AE_1) getrennten Unterauswerteeinheit (AE_2) erfasst werden.

12. Mess-System nach einem der vorhergehenden Ansprüche, **dadurch gekennzeichnet, dass** die Leitung zumindest zeitweise eine niederfrequente Spannung aufweist.

## Claims

1. A measurement system (1) for detection of faults on a wire of a device or a piece of equipment, comprising a determination unit (AE) and at least one sensor unit (51), wherein the measurement system (1) is further adapted to determine with reference to a fault, whether the fault is higher frequent or lower frequent with respect to a predetermined threshold frequency, wherein the measurement system (1) is further adapted to provide data associated to one or more fault(s), **characterized in that** in-between the sensor unit (S1) and the determination unit (AE) a transformer (Ü) having a primary side and a secondary side is arranged, whereby the sensor unit (S1) is connectable to the primary side.

2. The measurement system according to claim 1, **characterized in that** the measurement system (1) further comprises a communication interface (I/O).

3. The measurement system according to claim 1 or 2, **characterized in that** the sensor unit (S1) provides a differential signal.

4. The measurement system according to one of the precedent claims, **characterized in that** the determination unit (AE) comprises an analog/digital-converter.

5. The measurement system according to one of the precedent claims, **characterized in that** the sensor unit (S1) comprises an inductive sensor.

6. The measurement system according to one of the precedent claims, **characterized in that** in-between the sensor unit (S1) and the determination unit (AE) a transformer (Ü) having a primary side and a secondary side is arranged, whereby the transformer (Ü) is provided by means of tracks of a printed circuit board.

7. The measurement system according to one of the precedent claims, **characterized in that** the determination unit (AE) is arranged to monitor a plurality of sensor units (S1, .... S4).

8. The measurement system according to one of the precedent claims, **characterized in that** the threshold frequency for distinguishing higher frequent / lower frequent is selected from a range of 250 kHz to 1 MHz.

9. The measurement system according to one of the precedent claims, **characterized in that** further a connection towards a functional grounding (FE) is provided.

10. The measurement system according to one of the precedent claims, **characterized in that** low-frequency faults are detected in a first sub-determination unit (AE_1) and highfrequency faults are detected in a second sub-determination unit (AE_2).

11. The measurement system according to one of the precedent claims, **characterized in that** low-frequency faults are detected in a first sub-determination unit (AE_1) and highfrequency faults are detected in a second sub-determination unit (AE_2) electrically insulated from the first sub-determination unit (AE_1).

12. The measurement system according to one of the precedent claims, **characterized in that** the line comprises at least temporarily a low frequency voltage.

## Revendications

1. Système de mesure (1), destiné à détecter des dysfonctionnements sur une conduite d'un appareil ou d'une installation, comportant une unité d'évaluation (AE) et au moins une unité de détection (S1), le système de mesure (1) étant configuré par ailleurs en rapport à un dysfonctionnement pour constater si le dysfonctionnement est de fréquence plus élevée ou moins élevée par rapport à une fréquence limite prédéfinie, le système de mesure (1) étant configuré par ailleurs pour mettre à disposition des données se rapportant à un ou à plusieurs dysfonctionnement(s), **caractérisé en ce qu'**entre l'unité de détection (S1) et l'unité d'évaluation (AE) est placé un transmetteur (Ü) doté d'un côté primaire et d'un côté secondaire, l'unité de détection (S1) pouvant se raccorder sur le côté primaire.

2. Système de mesure selon la revendication 1, **caractérisé en ce que** le système de mesure (1) comporte par ailleurs une interface de communication (I / O).

3. Système de mesure selon la revendication 1 ou 2, **caractérisé en ce que** l'unité de détection (S1) met à disposition un signal différentiel.

4. Système de mesure selon l'une quelconque des revendications précédentes, **caractérisé en ce que** l'unité d'évaluation (AE) comporte un convertisseur analogique / numérique.

5. Système de mesure selon l'une quelconque des revendications précédentes, **caractérisé en ce que** l'unité de détection (S1) est un capteur inductif.

6. Système de mesure selon l'une quelconque des revendications précédentes, **caractérisé en ce qu'**entre l'unité de détection (S1) et l'unité d'évaluation (AE) est placé un transmetteur (Ü) doté d'un côté primaire et d'un côté secondaire, le transmetteur (Ü) étant réalisé au moyen de pistes conductrices d'une carte de circuit imprimé (PCB).

7. Système de mesure selon l'une quelconque des revendications précédentes, **caractérisé en ce que** l'unité d'évaluation (A) est configurée pour superviser une pluralité d'unités de capteurs (S1, ... S4).

8. Système de mesure selon l'une quelconque des revendications précédentes, **caractérisé en ce que** la fréquence limite pour la distinction de la haute fréquence / basse fréquence est sélectionnée dans une plage de 250 kHz à 1 MHz.

9. Système de mesure selon l'une quelconque des revendications précédentes, **caractérisé en ce qu'**il met à disposition par ailleurs une connexion sur une mise à la terre fonctionnelle (FE).

10. Système de mesure selon l'une quelconque des revendications précédentes, **caractérisé en ce que** des dysfonctionnements à basse fréquence sont détectés dans une première sous-unité AE_1) d'évaluation et **en ce que** les dysfonctionnements à haute fréquence sont détectés dans une deuxième sous-unité AE_2) d'évaluation.

11. Système de mesure selon l'une quelconque des revendications précédentes, **caractérisé en ce que** les dysfonctionnements à basse fréquence sont détectés dans une première sous-unité AE_1) d'évaluation et les dysfonctionnements à haute fréquence sont détectés dans une deuxième sous-unité AE_2) d'évaluation électriquement isolée de la première sous-unité AE_1) d'évaluation.

12. Système de mesure selon l'une quelconque des revendications précédentes, **caractérisé en ce que** la conduite présente au moins temporairement une tension basse fréquence.
